(19) Europäisches Patentamt

European Patent Office

Office européen des brevets

(11) **EP 1 114 466 B1**

(12) **EUROPÄISCHE PATENTSCHRIFT**

(45) Veröffentlichungstag und Bekanntmachung des Hinweises auf die Patenterteilung:
**26.07.2006  Patentblatt 2006/30**

(21) Anmeldenummer: **99929017.4**

(22) Anmeldetag: **22.04.1999**

(51) Int Cl.:
*H01L 29/78* (2006.01)          *H01L 29/06* (2006.01)
*H01L 21/336* (2006.01)

(86) Internationale Anmeldenummer:
**PCT/DE1999/001218**

(87) Internationale Veröffentlichungsnummer:
**WO 2000/014807 (16.03.2000 Gazette 2000/11)**

(54) **HOCHSPANNUNGS-HALBLEITERBAUELEMENT**

HIGH-VOLTAGE SEMICONDUCTOR COMPONENT

ELEMENT SEMI-CONDUCTEUR HAUTE TENSION

(84) Benannte Vertragsstaaten:
**AT DE FR GB IE IT**

(30) Priorität: **02.09.1998  DE 19840032**

(43) Veröffentlichungstag der Anmeldung:
**11.07.2001  Patentblatt 2001/28**

(73) Patentinhaber: **Infineon Technologies AG
81669 München (DE)**

(72) Erfinder:
 • **DEBOY, Gerald
  D-82008 Unterhaching (DE)**
 • **STENGL, Jens-Peer
  D-82284 Grafrath (DE)**
 • **STRACK, Helmut
  D-80804 München (DE)**
 • **WEBER, Hans
  D-83404 Ainring (DE)**

 • **GRAF, Heimo
  A-9711 Paternion (AT)**
 • **RÜB, Michael
  A-9500 Villach (AT)**
 • **AHLERS, Dirk
  D-81369 München (DE)**

(74) Vertreter: **Schäfer, Horst
Schweiger & Partner
Patent- und Rechtsanwälte
Karlstrasse 35
80333 München (DE)**

(56) Entgegenhaltungen:
**EP-A- 0 114 435          EP-A- 0 634 798
WO-A-97/29518          DE-A- 4 309 764
GB-A- 2 309 336          US-A- 4 801 995
US-A- 5 216 275          US-A- 5 726 469**

**Beschreibung**

Die vorliegende Erfindung betrifft ein Halbleiterbauelement mit einem einen sperrenden pn-Übergang aufweisenden Halbleiterkörper, einer ersten Zone eines ersten Leitungstyps, die mit einer ersten Elektrode verbunden ist und an eine den sperrenden pn-Übergang bildende Zone eines zweiten, zum ersten Leitungstyp entgegengesetzten Leitungstyps angrenzt, und mit einer zweiten Zone des ersten Leitungstyps, die mit einer zweiten Elektrode verbunden ist, wobei die der zweiten Zone zugewandten Seite der Zone des zweiten Leitungstyps eine erste Oberfläche bildet und im Bereich zwischen der ersten Oberfläche und einer zweiten Oberfläche, die zwischen der ersten Oberfläche und der zweiten Zone liegt, Gebiete des ersten und des zweiten Leitungstyps verschachtelt sind.

Derartige Halbleiterbauelemente werden auch als Kompensationsbauelemente bezeichnet. Bei solchen Kompensationsbauelementen handelt es sich beispielsweise um n- oder p-Kanal-MOS-Feldeffekttransistoren, Dioden, Thyristoren, GTO's oder auch andere Bauelemente. Im folgenden soll jedoch als Beispiel von einem Feldeffekt-Transistor (auch kurz "Transistor" genannt) ausgegangen werden.

Zu Kompensationsbauelementen gibt es, über einen langen Zeitraum verstreut, verschiedene theoretische Untersuchungen (vgl. US 4,754,310 und US 5,216,275), in denen jedoch speziell Verbesserungen des Einschaltwiderstandes $R_{DS}$(on) und nicht der Stabilität bei Strombelastung, wie insbesondere Robustheit hinsichtlich Avalanche und Kurzschluß im Hochstromfall bei hoher Source-Drain-Spannung, angestrebt werden.

Kompensationsbauelemente beruhen auf einer gegenseitigen Kompensation der Ladung von n- und p-dotierten Gebieten in der Driftregion des Transistors. Die Gebiete sind dabei räumlich so angeordnet, daß das Linienintegral über die Dotierung entlang einer vertikal zum pn-Übergang verlaufenden Linie jeweils unterhalb der materialspezifischen Durchbruchsladung bleibt (Silizium: ca. 2 x $10^{12}$ cm$^{-2}$). Beispielsweise können in einem Vertikaltransistor, wie er in der Leistungselektronik üblich ist, paarweise p- und n-Säulen oder Platten etc. angeordnet sein. In einer Lateralstruktur können p- und n-leitende Schichten lateral zwischen einem mit einer p-leitenden Schicht belegten Graben und einem mit einer n-leitenden Schicht belegten Graben abwechselnd übereinander gestapelt sein (vgl. US 4,754,310).

Durch die weitgehende Kompensation der p- und n-Dotierungen läßt sich bei Kompensationsbauelementen die Dotierung des stromführenden Bereichs (für n-Kanal-Transistoren der n-Bereich, für p-Kanal-Transistoren der p-Bereich) deutlich erhöhen, woraus trotz des Verlusts an stromführender Fläche ein deutlicher Gewinn an Einschaltwiderstand $R_{DS}$(on) resultiert. Die Sperrfähigkeit des Transistors hängt dabei im wesentlichen von der Differenz der beiden Dotierungen ab. Da aus Gründen der Reduktion des Einschaltwiderstandes eine um mindestens eine Größenordnung höhere Dotierung des stromführenden Gebiets erwünscht ist, erfordert die Beherrschung der Sperrspannung eine kontrollierte Einstellung des Kompensationsgrades, der für Werte im Bereich $\leq \pm$ 10 % definierbar ist. Bei einem höheren Gewinn an Einschaltwiderstand wird der genannte Bereich noch kleiner. Der Kompensationsgrad ist dabei definierbar durch

$$(\text{p-Dotierung} - \text{n-Dotierung})/\text{n-Dotierung}$$

oder durch

Ladungsdifferenz/Ladung eines Dotierungsgebiets. Es sind aber auch andere Definitionen möglich.

Es ist Aufgabe der vorliegenden Erfindung, ein robustes Halbleiterbauelement der eingangs genannten Art zu schaffen, das sich einerseits durch eine hohe Avalanchefestigkeit und große Strombelastbarkeit vor bzw. im Durchbruch auszeichnet und andererseits im Hinblick auf technologische Schwankungsbreiten von Herstellungsprozessen mit gut reproduzierbaren Eigenschaften einfach herstellbar ist.

Diese Aufgabe wird bei einem Halbleiterbauelement der eingangs genannten Art erfindungsgemäß dadurch gelöst, daß die Gebiete des ersten und des zweiten Leitungstyps derart variabel dotiert sind, daß in Bereichen nahe der ersten Oberfläche Dotierstoffatome des zweiten Leitungstyps und in Bereichen nahe der zweiten Oberfläche Dotierstoffatome des ersten Leitungstyps überwiegen.

In bevorzugter Weise reichen die Gebiete des zweiten Leitungstyps nicht bis zu der zweiten Zone, so daß zwischen dieser zweiten Oberfläche und der zweiten Zone ein schwach dotierter Bereich des ersten Leitungstyps verbleibt. Es ist aber möglich, die Breite dieses Bereiches gegen "null" gehen zu lassen. Der schwach dotierte Bereich liefert aber verschiedene Vorteile, wie Erhöhung der Sperrspannung, "weicher" Verlauf der Feldstärke oder Verbesserung der Kommutierungseigenschaften der Inversdiode.

In einer anderen Weiterbildung der Erfindung ist es vorgesehen, daß zwischen der ersten und zweiten Oberfläche ein durch die Dotierung bewirkter Kompensationsgrad derart variiert ist, daß nahe der ersten Oberfläche Atomrümpfe des zweiten Leitungstyps und nahe der zweiten Oberfläche Atomrümpfe des ersten Leitungstyps dominieren. Es liegen also Schichtenfolgen p, p⁻, n⁻, n oder n, n⁻, p⁻, p zwischen den beiden Oberflächen vor.

Vorteilhafte Weiterbildungen des erfindungsgemäßen Halbleiterbauelements (im folgenden auch Kompensationsbauelement genannt) ergeben sich aus den weiteren Unteransprüchen.

Die Wirkung der ineinander verschachtelten Gebiete, abwechselnd unterschiedlichen Leitungstyps, auf das elektrische Feld ist im Unterschied zu beispielsweise einem klassischen DMOS-Transistor wie folgt ("lateral" und "vertikal" beziehen sich im folgenden auf einen Vertikaltransistor):

(a) Es existiert ein zur Verbindungsrichtung zwischen den Elektroden "laterales" Querfeld, dessen Stärke vom Anteil der lateralen Ladung (Linienintegral senkrecht zum lateralen pn-Übergang) relativ zur Durchbruchsladung abhängt. Dieses Feld führt zur Trennung von Elektronen und Löchern und zu einer Verringerung des stromtragenden Querschnitts entlang der Strompfade. Diese Tatsache ist für das Verständnis der Vorgänge im Avalanche, der Durchbruchskennlinie und des Sättigungsbereichs des Kennlinienfeldes von prinzipieller Bedeutung.

(b) Das zur Verbindungsrichtung zwischen Elektronen parallele "vertikale" elektrische Feld wird lokal von der Differenz der benachbarten Dotierungen bestimmt. Dies bedeutet, daß sich bei einem Überschuß von Donatoren (n-Lastigkeit: die Ladung in den n-leitenden Gebieten überwiegt die Ladung der p-Gebiete) einerseits eine DMOS-ähnliche Feldverteilung (Maximum des Felds am sperrenden pn-Übergang, in Richtung gegenüberliegender Bauelementrückseite abnehmendes Feld) einstellt, wobei der Gradient des Felds jedoch deutlich geringer ist, als es der Dotierung des n-Gebiets alleine entsprechenden würde. Andererseits ist jedoch durch Überkompensation des n-leitenden Gebietes mit Akzeptoren eine in Richtung Rückseite ansteigende Feldverteilung möglich (p-Lastigkeit, Überschuß der Akzeptoren gegenüber den Donatoren). Das Feldmaximum liegt in einer solchen Auslegung am Boden des p-Gebiets. Kompensieren sich die beiden Dotierungen exakt, ergibt sich eine horizontale Feldverteilung.

Mit einer exakt horizontalen Feldverteilung wird das Maximum der Durchbruchsspannung erreicht. Überwiegen die Akzeptoren oder die Donatoren, nimmt die Durchbruchsspannung jeweils ab. Trägt man folglich die Durchbruchsspannung als Funktion des Kompensationsgrads auf, ergibt sich ein parabelförmiger Verlauf.

Eine konstante Dotierung in den p- und n-leitenden Gebieten oder auch eine lokal variierende Dotierung mit periodischen Maxima gleicher Höhe führt dabei zu einem vergleichsweise scharf ausgeprägten Maximum der "Kompensationsparabel". Zu Gunsten eines "Fertigungsfensters" (Einbeziehung der Schwankungen aller relevanter Einzelprozesse) muß eine vergleichsweise hohe Durchbruchsspannung angepeilt werden, um verläßliche Ausbeuten und Produktionssicherheit zu erreichen. Ziel muß es daher sein, die Kompensationsparabel möglichst flach und breit zu gestalten.

Wird an das Bauelement Sperrspannung angelegt, so wird die Driftstrecke, d.h. der Bereich der paarweise angeordneten Gebiete entgegengesetzter Dotierung, von beweglichen Ladungsträgern ausgeräumt. Es verbleiben die positiv geladenen Donatorrümpfe und die negativ geladenen Akzeptorrümpfe in der sich aufspannenden Raumladungszone. Sie bestimmen dann zunächst den Verlauf des Felds.

Der Stromfluß durch die Raumladungszone bewirkt eine Veränderung des elektrischen Felds, wenn die Konzentration der mit dem Stromfluß verbundenen Ladungsträger in den Bereich der Hintergrunddotierung kommt. Elektronen kompensieren dabei Donatoren, Löcher die Akzeptoren. Für die Stabilität des Bauelements ist es also sehr wichtig, welche Dotierung lokal überwiegt, wo Ladungsträger erzeugt werden und wie sich ihre Konzentrationen entlang ihrer Strompfade einstellen.

Für die folgenden Ausführungen wird zum Verständnis der Basismechanismen, zunächst eine konstante Dotierung der p- und n-leitenden Gebiete angenommen.

Im eingeschalteten Zustand und insbesondere im Sättigungsbereich des Kennlinienfeldes eines MOS-Transistors fließt ein reiner Elektronenstrom aus dem Kanal in ein n-dotiertes Gebiet, bei einem Vertikaltransistor auch "Säule" genannt, wobei in der Tiefe eine zunehmende Fokussierung des Stromflusses aufgrund des elektrischen Querfelds eintritt. Hochstrom-Stabilität wird durch Überwiegen der n-Dotierung gefördert; da jedoch der Kanalbereich mit seinem positiven Temperaturkoeffizienten eine inhomogene Stromverteilung in einem Zellenfeld unterbindet, ist diese Betriebsart eher unkritisch. Eine Reduktion der Stromdichte läßt sich durch partielle Abschattung des Kanalanschlusses erreichen (vgl. DE 198 08 348 A1).

Für die Durchbruchskennlinie bzw. deren Verlauf ist folgendes zu beachten: Die Erzeugung von Elektronen und Löchern erfolgt im Bereich maximaler Feldstärke. Die Trennung beider Ladungsträgerarten wird durch das elektrische Querfeld vorgenommen. Entlang beider Strompfade im p- bzw. n-Gebiet tritt eine Fokussierung und weitere Multiplikation ein. Schließlich tritt auch keine Wirkung einer partiellen Kanalabschattung ein. Stabilität liegt nur dann vor, wenn die beweglichen Ladungsträger außerhalb ihrer Entstehungsorte zu einem Anstieg des elektrischen Felds und damit zu einem Anstieg der Durchbruchsspannung der jeweiligen Zelle führen. Für Kompensationsbauelemente bedeutet dies Stabilität im p- und n-lastigen Bereich, jedoch nicht im Maximum der Kompensationsparabel. Im p-lastigen Bereich erfolgt der Durchbruch am "Boden" der Säule. Die Elektronen fließen aus der Driftregion heraus und beeinflussen das Feld somit nicht. Die Löcher werden durch das elektrische Längsfeld zum oberseitigen Source-Kontakt gezogen. Dabei wird der Löcherstrom längs seines Weges durch das elektrische Querfeld fokussiert: die Stromdichte steigt hier an. Damit wird das elektrische Längsfeld zunächst oberflächennah beeinflußt. Infolge der Kompensation der überschüssigen Akzeptorrümpfe (p-Lastigkeit) ergibt sich eine Reduktion des Gradienten des elektrischen Felds und ein Anstieg der Durchbruchsspannung. Diese Situation ist solange stabil, als das Feld dort deutlich unterhalb der kritischen Feldstärke (für Silizium: etwa 270 kV/cm für eine Ladungsträgerkonzentration von ca. 1015 cm$^{-3}$) bleibt.

Im n-lastigen Bereich mit einem Überschuß an Donatoren ist der Durchbruch oberflächennah. Die Löcher fließen zum Source-kontakt und beeinflussen das Feld noch auf dem Weg von ihren Entstehungsort bis zu p-Wanne. Ziel muß es daher sein, den Durchbruchsort möglichst nahe an die p-Wanne heranzulegen. Dies kann beispielsweise durch eine lokale Anhebung der n-Dotierung geschehen. Die Elektronen fließen durch die komplette Driftzone zur Rückseite und beeinflussen das Feld ebenfalls entlang ihres Strompfads. Stabilität wird dann erzielt, wenn die Wirkung des Elektronenstroms die des Löcherstroms überwiegt. Da hier die Geometrie der Zellenanordnung eine wichtige Rolle spielt, gibt es insbesondere nahe des Maximums der Kompensationsparabel einen Bereich stabiler und instabiler Kennlinien.

Die Verhältnisse im Avalanche sind sehr ähnlich zu denjenigen bei einem Durchbruch. Die Ströme sind jedoch deutlich höher und betragen bei einem Nennstrom bis zum Doppelten des Nennstromes des Transistors. Da das elektrische Querfeld immer eine deutliche Fokussierung des Stroms bewirkt, wird bei Kompensationsbauelementen bei vergleichsweise geringer Strombelastung der Stabilitätsbereich verlassen. Physikalisch bedeutet dies, daß der strominduzierte Feldanstieg bereits so weit fortgeschritten ist, daß lokal die Durchbruchsfeldstärke erreicht wird. Das elektrische Längsfeld kann dann lokal nicht mehr weiter ansteigen, die Krümmung des elektrischen Längsfelds nimmt jedoch weiter zu, woraus ein Rückgang der Durchbruchsspannung der betroffenen Zelle resultiert. In der Kennlinie einer Einzelzelle und auch in der Simulation zeigt sich dies durch einen negativen differentiellen Widerstand; d.h. die Spannung geht mit ansteigendem Strom zurück. In einem großen Transistor mit mehreren 10.000 Zellen wird dies zu einer sehr raschen inhomogenen Umverteilung des Stroms führen. Es bildet sich ein Filament, und der Transistor schmilzt lokal auf.

Daraus ergeben sich die folgenden Konsequenzen für die Stabilität von Kompensationsbauelementen:

(a) Durch die Trennung von Elektronen und Löchern kommt es nicht wie bei IGBT's und Dioden zu einer "Autostabilisierung". Vielmehr müssen Kompensationsgrad, Feldverteilung und Durchbruchsort exakt eingestellt werden.

(b) Auf der Kompensationsparabel gibt es bei konstanter Doterierung der p- und n-Gebiete bzw. "Säulen" stabile Bereiche im deutlich p- und im deutlich n-lastigen Bereich. Beide Bereiche hängen nicht zusammen. Damit ergibt sich nur ein extrem kleines Fertigungsfenster. Die Kompensationsparabel ist bei konstanter Dotierung der p- und n-Gebiete bzw. Säulen überaus steil. Der Durchbruchsort verlagert sich innerhalb weniger Prozente vom Boden der p-Säule in Richtung Oberfläche.

(c) Für jedes Kompensationsbauelement gibt es eine Stromzerstörungsschwelle im Avalanche, die unmittelbar mit dem Kompensationsgrad gekoppelt ist. Der Kompensationsgrad bestimmt andererseits die erzielbare Durchbruchsspannung und hat Einfluß auf den $R_{DS}$(on)-Gewinn.

(d) Bei konstanter Dotierung der p- und n-Gebiete sind - wie oben gesagt - die Bauelemente nahe des Maximums der Kompensationsparabel instabil. Dies führt dazu, daß die Bauelemente mit der höchsten Sperrspannung im Avalanche-Test zerstört werden.

Wie oben erläutert wurde, wird zur Vermeidung der Nachteile der Kompensationsgrad längs der Dotierungsgebiete, d.h. bei einer Vertikalstruktur von der Oberseite in Richtung Rückseite des Transistors, so variiert, daß nahe der Oberfläche die Atomrümpfe des zweiten Leitungstyps und nahe der Rückseite die Atomrümpfe des ersten Leitungstyps vorherrschen.

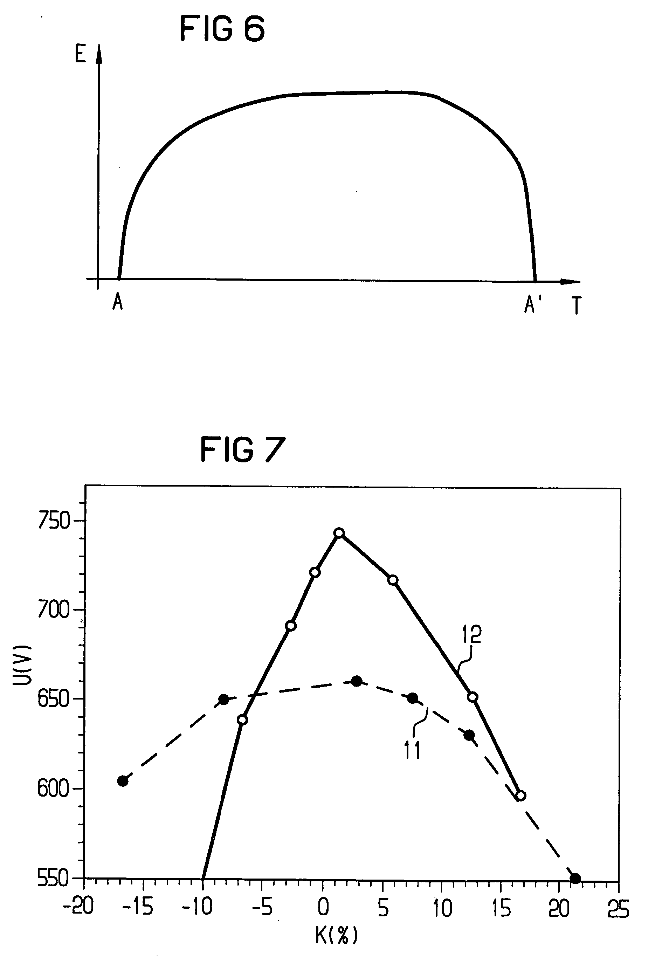

Die resultierende Feldverteilung weist einen "buckelförmigen" Verlauf mit einem Maximum in etwa halber Tiefe auf (vgl. Figur 6). Damit beeinflussen sowohl die Elektronen als auch die Löcher im Durchbruch und im Avalanche die Feldverteilung. Beide Ladungsträgerarten wirken stabilisierend, da sie von ihrem Entstehungsort aus jeweils in Gebiete laufen, in denen sie die dominierende, überschüssige Hintergrunddotierung kompensieren. Es gibt so einen durchgehenden Stabilitätsbereich von p-lastigen bis zu n-lastigen Kompensationsgraden.

Eine Variation des Kompensationsgrades durch Fertigungsschwankungen verschiebt den Durchbruchsort in vertikaler Richtung nur wenig und auch kontinuierlich hin und her, solange diese Variation kleiner ist als die technologisch eingestellte Variation des Kompensationsgrads. Die Größe dieser Modifikation des Kompensationsgrads bestimmt auch die Grenzen des Stabilitätsbereichs. Damit wird das Fertigungsfenster frei wählbar.

Die Fokussierung der Ströme ist deutlich geringer ausgeprägt, da beide Ladungsträgerarten nur jeweils die halbe Wegstrecke im Bereich des komprimierenden elektrischen Querfelds zurücklegen. Damit werden die Bauelemente im Avalanche mit deutlich höheren Strömen belastbar.

Da bei einer Variation des Kompensationsgrads z.B. in Richtung auf "n-Lastigkeit" das elektrische Feld jeweils im oberen Bereich der Driftstrecke zunimmt, im unteren Bereich aber gleichzeitig abnimmt (bei Variation in Richtung auf p-Lastigkeit umgekehrt), variiert die Durchbruchsspannung als Funktion des Kompensationsgrads nur relativ wenig. Damit wird die Kompensationsparabel vorzugsweise flach und breit.

Die vertikale Variation des Kompensationsgrades kann durch Variation der Dotierung im p-Gebiet oder durch Variation der Dotierung im n-Gebiet oder durch Variation der Dotierung in beiden Gebieten erfolgen. Die Variation der Dotierung längs der Säulen kann eine konstante Steigung aufweisen oder in mehreren Stufen erfolgen. Grundsätzlich steigt die Variation jedoch monoton von einem p-lastigen Kompensationsgrad zu einem n-lastigen Kompensationsgrad an.

Die Erfindung kann ohne weiteres auch bei p-Kanal-Transistoren angewandt werden. Es tritt dann ein entsprechend geänderter Verlauf der Halbleitergebiete auf: Ein (p, p-dominiert, n-dominiert, n)-Verlauf wird durch einen (n, n-dominiert, p-dominiert, p)-Verlauf ersetzt.

Die Grenzen der Stabilität werden auf der n-lastigen Seite erreicht, wenn das Feld oberflächennah über einen merklichen Bereich der Driftstrecke horizontal verläuft. Auf der p-lastigen Seite erreicht man die Stabilitätsgrenze, wenn das Feld nahe des Bodens des kompensierenden Säulenbereichs über einen merklichen Bereich der Driftstrecke horizontal verläuft.

Generell gilt, daß die Kompensationsparabel um so flacher und breiter wird, je größer der Gradient des Kompensationsgrads ist. Die Durchbruchsspannung im Maximum der Kompensationsparabel sinkt entsprechend.

Eine weitere wichtige Limitierung der Variation des Kompensationsgrads wird durch die Forderung nach Unterschreitung der Durchbruchsladung gegeben. Darüber hinaus treten bei starker Anhebung der p-Säulen-Dotierung nahe der Oberfläche Stromeinschnürungseffekte auf (lateraler JFET-Effekt).

Für 600 V-Bauelemente ist beispielsweise eine Variation des Kompensationsgrads längs der p- und n-Gebiete von 50 % vorteilhaft.

Obwohl oben primär von einem Vertikal-Transistor ausgegangen wurde, kann das erfindungsgemäße Halbleiterbauelement grundsätzlich eine Vertikal- oder auch eine Lateral-Struktur haben. Bei einer Lateral-Struktur sind z.B. $n^-$-und $p^-$-leitende plattenförmige Gebiete lateral ineinander gestaffelt angeordnet.

Anwendungen für solche Lateraltransistoren sind beispielsweise im Smart-Power-Bereich oder auch in der Mikroelektronik zu sehen; Vertikaltransistoren werden dagegen vorwiegend in der Leitungselektronik erzeugt.

Die vertikale Modifikation des Kompensationsgrades ist sehr einfach umzusetzen, da in den einzelnen Epitaxieebenen nur die Implantationsdosis verändert werden muß. Die "echte" Kompensationsdosis wird dann in der mittleren Epitaxieschicht implantiert, darunter z.B. jeweils 10 % weniger, darüber z.B. jeweils 10 % mehr. Anstelle der Implantationsdosis kann aber auch die Epitaxiedotierung geändert werden.

Durch die größere beherrschbare Streuung ist es möglich, die Herstellungskosten zu verringern. Die Zahl der notwendigen Epitaxieschichten kann reduziert werden, und die Öffnungen für die Kompensations-Implantation können infolge höherer Streuung der implantierten Dosis durch die größere relative Streuung des Lackmaßes bei gleichzeitig verlängerter Nachdiffusion für das Zusammendiffundieren der einzelnen p-Bereiche zur "Säule" verkleinert werden.

Die erfindungsgemäße Struktur wird beispielsweise durch folgende Einzelschritte hergestellt:

Zunächst wird eine mehrere μm-dicke, n-dotierte Epitaxieschicht auf ein Halbleitersubstrat aufgebracht. In diese Epitaxieschicht werden über eine Resist-Maske mittels Ionenimplantation die p-dotierenden Ionen eingebracht. Anschließend wird der gesamte Vorgang so oft wiederholt, bis eine genügend dicke n-Multi-Layer-Epitaxieschicht mit eingelagerten zueinander justierten und übereinander gestapelten p-Zentren vorliegt. Nun erfolgt die Herstellung des eigentlichen Bauelements, durch die Prozessierung beispielsweise der Basiszonen, Sourcezonen, der Frontmetallisierung und der Gateelektroden bei einem Feldeffekttransistor. Durch thermische Ausdiffusion schließen sich die p-dotierten Zentren zu einer welligen vertikalen Säule zusammen. Wegen der intrinsischen Kompensation ist die Konzentration des p- oder n-dotierenden Stoffes immer wesentlich höher als die resultierende elektrisch aktive Dotierung.

Die Welligkeit der vertikalen Säule äußert sich auch in einem variierenden Akzeptor-Donator-Verhältnis $k_e(z)$ je Horizontal ebene. Die elektrische Kompensation variiert demnach in jeder Horizontalebene im Halbleiterkörper. Die Welligkeit der Säule bewirkt keine wesentliche Änderung des Horizontalfeldes. Deshalb wird in erster Näherung der Beitrag $U_{Bh}$ als unbeeinflußt von der Welligkeit betrachtet.

In senkrechter Richtung wechseln sich nun aber Schichten mit nicht horizontal-kompensierten p- und n-Ladungen ab. Eine Epitaxieschicht entspricht einer vollständigen Welligkeitsperiode und entspricht demnach zwei benachbarten pn-Übergängen. Durch die Fertigungsschwankungen bei den Epitaxiezyklen ist die Ladungsbilanz über das Gesamtvolumen eines pn-Übergangs nicht ausgeglichen, so daß der Kompensationsgrad ungleich 0 ist.

Bei einem Halbleiterbauelement nach der vorliegenden Erfindung muß die im gesperrten Zustand im Zellenfeld zwischen Anode und Katode bzw. bei einem Feldeffekttransistor zwischen Source- und Drain vertikal aufgenommene Spannung auch am Halbleiterbauelementrand in lateraler Richtung abgebaut werden. Halbleiterbauelemente werden oftmals bis in den Durchbruch betrieben. In diesem Fall fließt durch die eintretende Stoßionisation ein sehr hoher Strom. Um das Halbleiterbauelement nicht zu zerstören, dürfen keine allzu hohen Stromdichten auftreten, d.h. der Durchbruchsstrom muß sich möglichst gleichmäßig über das gesamte Halbleiterbauelement verteilen. Diese Forderung kann aber nur dann erfüllt werden, wenn das Zellenfeld den größten Anteil dieses Stromes führt. Bricht das Halbleiterbauelement in der Randstruktur bei kleineren Sperrspannungen durch als das Zellenfeld, so führt dies in den meisten Fällen zu irreversiblen thermischen Schädigungen des Halbleiterbauelements. Das Halbleiterbauelement muß demnach Avalanche-fest sein. Avalanche-feste Halbleiterbauelemente, insbesondere Vertikaltransistoren reduzieren den zur Beherrschung von überspannungen erforderlichen Sperrspannungs-Sicherheitsabstand, wodurch in vielen Anwendungen vergleichsweise niedersperrende Transistoren eingesetzt werden können, die bei gleichem $R_{DS}$(on) mit einer vergleichweise kleinen Halbleiterbauelementfläche auskommen und damit kostengünstiger sind. Bei konventionellen Hochvolt-MOSFET ist dies von sehr großer Bedeutung, weil der $R_{DS}$(on) dieser Transistoren überproportional mit der Durchbruchspannung ansteigt. Bei konventionellen Leistungsbauelementen führen aufwendige oberflächenpositionierte oder oberflächennahe Strukturen gewöhnlich dazu, daß der Halbleiterbauelementrand mehr Spannung sperren kann, als das Zellenfeld. Das tieferliegende Halbleiterbauelementvolumen ist homogen so niedrig dotiert, daß ohne Strukturierung die geforderte Spannung hält. Bei den Halbleiterbauelementen gemäß der vorliegenden Erfindung, die das Herstellungsverfahren der intrinsischen Kompensation nutzten, verschärfen sich die Anforderungen bezüglich der Randstruktur, denn hier muß auch das tieferliegende Volumen unter dem Rand bearbeitet werden. Das die Sperrspannung eigentlich aufnehmende Material, nämlich die Epitaxieschicht über dem hochdotierten Halbleitersubstrat, ist relativ niederohmig und wird nur einen Bruchteil der geforderten Spannung sperren. Erst durch das Einbringen der entgegendotierten Säulen wird die Sperrfähigkeit für das Zellenfeld erreicht.

Für das Volumen unter dem Rand ergeben sich grundsätzlich zwei unterschiedliche Bearbeitungsmethoden:

1. Der Halbleiterrand kann, getrennt vom Zellenfeld, d.h. in zusätzlichen Schritten, bearbeitet werden. Denkbar ist eine ganzflächige Gegendotierung des Trägermaterials am Halbleiterrand, z.B. mittels ganzflächiger Randimplantation und Ausdiffusion. Dadurch kann ein ganzflächig intrinsisch kompensierter und damit hochsperrender Rand gefertigt werden. Eine solche Vorgehensweise ist jedoch mit sehr hohen Kosten verbunden.

2. Die Säulenstruktur im Zellenfeld wird bis in den Rand fortgesetzt, womit das Trägermaterial auch dort zu grundsätzlich gleichen Sperrspannungen wie im Zellenfeld aufgestockt wird. Eine z.B. minimale Erhöhung der Randspannungsfestigkeit läßt sich in vielen Fällen durch eine geeignete Variation des tiefen Kompensationsprofils der Säulen erzielen, wie dies auf den vorhergehenden Seiten für das Zellenfeld beschrieben worden ist, womit allerdings der Toleranzbereich gegenüber dem Zellenfeld und damit der Toleranzbereich des gesamten Halbleiterbauelements kleiner wird. Zudem kommt, daß Zusatzeffekte den Durchbruch am Halbleiterbauelementrand provozieren können.

Zum einen bewirken die oberflächennahen oder oberflächenpositionierten Randstrukturen eine zusätzliche Feldverbiegung und generieren Zentren hoher Feldstärke.

Zum anderen kann es nötig sein, den Rand mit einer gezielten negativen "Fehlladung" zu belegen, die eine Krümmung der Äquipotentiallinien in Richtung der Halbleiterbauelementoberfläche bewirkt, womit diese von der Oberflächenstruktur aufgenommen und geführt werden können. Dies entspricht einem Feldabbau am Halbleiterbauelementrand. Dieses Ladungsfehlverhältnis kann ebenfalls zu einem spannungsmäßig verfrühten Durchbruch des Halbleiterbauelementrandes gegenüber dem Zellenfeld führen.

Demnach ist es am besten, am Rand die Horizontalkomponente des elektrischen Feldes und zugleich die vertikale Welligkeit des Kompensationsprofils zu reduzieren. Beides führt zu höheren Sperrspannungen am Halbleiterbauelementrand. Um dies umzusetzen, muß die örtliche Trennung in Ladungszentren entgegengesetzter Polarität aufgehoben oder zumindest abgeschwächt werden, d.h. also eine intrinsische Kompensation vorgenommen werden.

Es entsteht somit eine hochspannungsfeste Randstruktur, die aus mehreren floatenden Zonen vom zweiten Leitungstyp besteht, die von Zwischenzonen vom ersten Leitungstyp getrennt sind, wobei die Breite der Zwischenzonen und die Breite der floatenden Zonen kleiner als die Breiten der Gebiete des ersten und des zweiten Leitungstyps sind, die innerhalb des Zellenfeldes ineinander verschachtelt vorliegen. Diese floatenden Zonen und die Zwischenzonen sind so dotiert, daß sich die Ladungsträger der floatenden Zonen und der Zwischenzonen bei angelegter Sperrspannung vollständig ausräumen.

Vorzugsweise wird also das Randvolumen in ein- und demselben Arbeitsgang wie das Zellenfeld bearbeitet, wobei sowohl die Dicke einer einzelnen Epitaxieschicht als auch das Zellraster im Randbereich verkleinert wird, so ergibt sich nach Prozeßende für jede Randzelle eine homogenisierte Dotierstoffverteilung für beide Ladungsträgersorten. über das Verhältnis der unmaskierten Fläche pro Zelle zur Gesamtzellfläche im Randbereich kann die über Implantation eingebrachte Ladung ideal an die Ladung angepaßt werden, die über die Epitaxie definiert wird. Um eine ideale Sperrfähigkeit zu erreichen, wird man einen Ladungsausgleich, d.h. intrinsisch kompensierte Verhältnisse anstreben.

Vorzugweise wird man die Dicke der Einzelepitaxieschichten nach Anforderungen auslegen, die das Zellenfeld vorgibt. Dadurch ergibt sich auch am Halbleiterrand weiterhin ein vertikal welliges Kompensationsprofil, jedoch in wesentlich abgeschwächter Form, als im Zellenfeld. Eine Reduzierung des Zellrasters führt nämlich auch dazu, daß die Auflösung der Dotierstoffquellen herabgesetzt wird, wodurch die Grenzen der einzelnen Diffusionsfronten verschwimmen.

Ein weiterer Vorteil des beschriebenen Randkonzepts ist die Kopplung zwischen den Fertigungsfehlern im Rand und im Zellenfeld, da sich Fehlermechanismen in beiden Bereichen in gleicher Richtung auswirken.

Nachfolgend wird die Erfindung anhand der Zeichnungen näher erläutert. Es zeigen:

Figur 1　　einer Draufsicht auf einen n-Kanal-Lateral-MOS-Transistor nach einem ersten Ausführungsbeispiel der Erfindung,

Figur 2　　eine Schnittdarstellung eines n-Kanal-Lateral-MOS-Transistors mit V-förmigen Gräben nach einem zweiten Ausführungsbeispiel der Erfindung,

Figuren 3a bis 3d　　verschiedene Layouts bei dem erfindungsgemäßen Halbleiterbauelement,

Figur 4　　einen Schnitt durch einen n-Kanal-MOS-Transistor nach einem dritten Ausführungsbeispiel der Erfindung,

Figur 5　　den Verlauf des Kompensationsgrades K längs einer Linie C-D in Figur 4,

Figur 6　　den Verlauf des elektrischen Feldes längs der Linie C-D in Figur 4,

Figur 7　　den Verlauf der Durchbruchssparnung in Abhängigkeit von dem Kompensationsgrad für eine konstante Dotierung und eine variable Dotierung,

Figur 8　　ein konkretes Beispiel für ein Zelldesign für einen n-Kanal-MOS-Transistor,

Figuren 9a bis 9c　　verschiedene quadratische Randstrukturlayouts bei dem erfindungsgemäßen Halbleiterbauelement,

Figuren 10a bis 10c　　verschiedene streifenförmige Randstrukturlayouts bei dem erfindungsgemäßen Halbleiterbauelement,

Figur 11　　ein hexagonales Randstrukturlayout bei dem erfindungsgemäßen Halbleiterbauelement,

Figur 12　　einen Schnitt durch einen n-Kanal-MOS-Transistor nach einem vierten Ausführungsbeispiel mit einem Randstrukturlayout, und

Figur 13　　einen Schnitt durch einen n-Kanal-MOS-Transistor nach einem fünften Ausführungsbeispiel mit einem weiteren Randstrukturlayout.

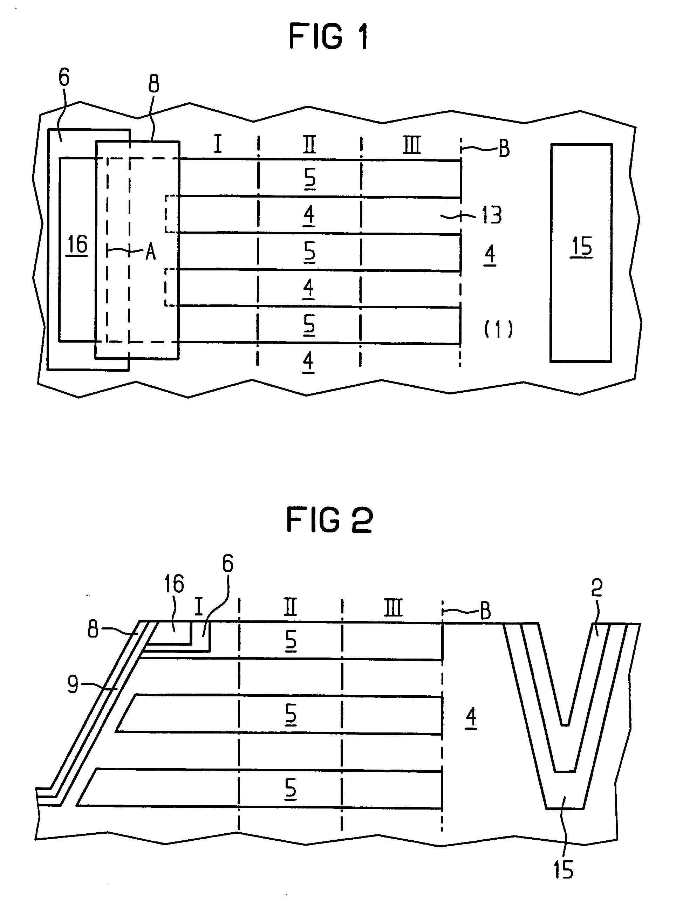

Figur 1 zeigt eine Draufsicht auf einen n-Kanal-MOS-Transistor mit einer $n^+$-leitenden Drainzone 15, einer $n^+$-leitenden Sourcezone 16, einer Gateelektrode 8 und einem p-leitenden Gebiet 5. Dieses p-leitende Gebiet 5 erstreckt sich fingerförmig in ein n-leitendes Gebiet 4 auf einem Halbleitersubstrat 1, so daß die Gebiete 4 und 5 ineinander "verschachtelt" sind. Die Gateelektrode 8 kann beispielsweise aus polykristallinem Silizium bestehen, während eine unterhalb dieser Gateelektrode 8 vorhandene und in der Figur 1 nicht gezeigte Isolierschicht beispielsweise aus Siliziumdioxid und/oder Siliziumnitrid aufgebaut ist. In dem p-leitenden Gebiet 5 sind in einer Zone I ein p-Ladungsüberschuß, in einer Zone II eine "neutrale" Ladung in einer Zone III ein n-Ladungsüberschuß vorhanden. Dies bedeutet, daß im Gebiet 5 in der Zone I die p-Ladung die Ladung des umgebenden n-leitenden Gebietes 5 überwiegt, daß weiterhin in der Zone II die p-Ladung genau der Ladung des umgebenden n-leitenden Gebietes 5 kompensiert und daß in der Zone III die p-Ladung geringer ist als die Ladung des umgebenden n-leitenden Gebietes 5. Wesentlich ist also, daß die Ladung des p-Gebietes 5 variabel ist, während die Ladung der n-Gebiete 4 jeweils konstant ist.

Das p-leitende Gebiet 5 reicht vom Rand der Sourcezone 16, also einer Fläche A bis zu einer strichliert angedeuteten Fläche B im n-leitenden Gebiet 4. Diese Fläche B ist von der Drainzone 15 beabstandet, so daß zwischen der Fläche B und der Drainzone 15 ein n-leitender Bereich 13 besteht, in welchem keine "Verschachtelung" mit p-leitenden Gebieten 5 vorliegt. Es ist aber auch möglich, die Fläche B bis zu dem Rand der Drainzone 15 zu verlagern, so daß kein n-leitender Bereich 13 vorliegt. In vorteilhafter Weise ist aber die Fläche B von der Drainelektrode 15 beabstandet, was zu einer Erhöhung der Sperrspannung, einem weicheren Verlauf des elektrischen Feldes und einer Verbesserung der Kommutierungseigenschaften der Inversdiode führt.

Figur 2 zeigt einen Schnitt durch ein weiteres Ausführungsbeispiel des erfindungsgemäßen Halbleiterbauelements in der Form eines n-Kanal-MOS-Transistors mit einer Drainelektrode 2 und einer Gate-Isolierschicht 9 zwischen der Gateelektrode 8 und dem Kanalbereich, der unterhalb der Isolierschicht 9 zwischen einer Sourcezone 16 und einer Drainzone 15 in einem p-leitenden Gebiet 5 vorgesehen ist. Auch bei diesem Ausführungsbeispiel weisen die p-leitenden Gebiete 5 in den Zonen I, II und III eine variable Dotierung auf, wie dies oben anhand der Figur 1 erläutert wurde.

Die Ausführungsbeispiele der Figur 1 und 2 zeigen zwei bevorzugte Gestaltungsmöglichkeiten für Lateralstrukturen des erfindungsgemäßen Halbleiterbauelementes. Wesentlich bei beiden Strukturen ist, daß in den Gebieten 5 die angegebene variable Dotierung vorliegt und daß diese Gebiete 5 die Drainzone 15 nicht erreichen, also in einer Fläche B im Abstand von dieser Drainzone 15 enden. Gegebenenfalls ist es aber möglich, die Fläche B bis an den Rand der Drainzone 15 heranzuführen. Wie oben gesagt, kann der Kompensationsgrad dabei durch Variation der Dotierung der p-leitenden Gebiete 5 oder der n-leitenden Gebiete 4 erzielt werden.

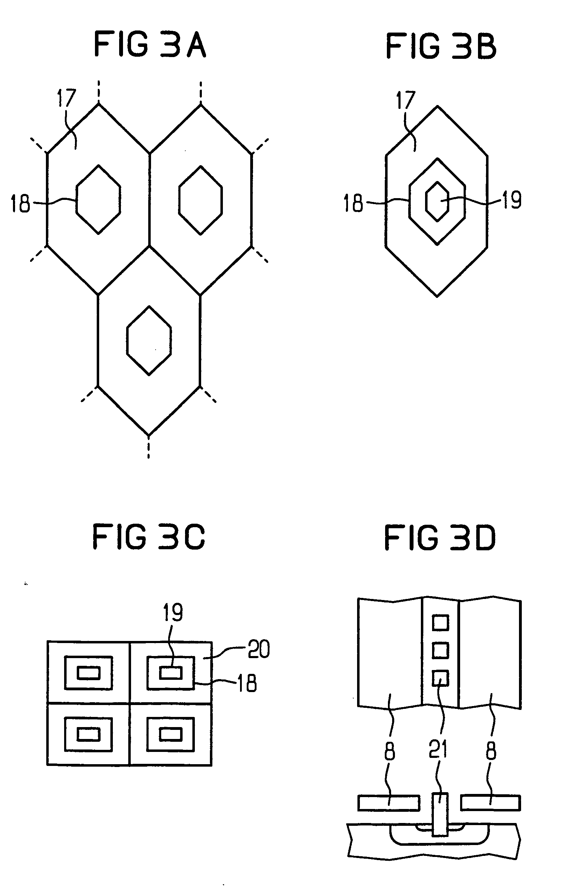

Die Figuren 3a bis 3d zeigen verschiedene Layouts für das erfindungsgemäße Halbleiterbauelement mit Sechseck-Polysilizium-Strukturen 17 und Polysilizium-Öffnungen 18 (Figur 3a), in denen gegebenenfalls Aluminium-Kontaktlöcher 19 (Figur 3b) vorgesehen sein können. Figur 3c zeigt ein Layout mit Rechteck-Polysilizium-Strukturen 20 und entsprechenden Polysilizium-Öffnungen 18 und Aluminium-Kontaktlöchern 19, während Figur 3d schematisch in Draufsicht und Schnittdarstellung eine Streifenstruktur mit Polysilizium-Gate-Elektroden 8 und Aluminium-Elektroden 21 angibt.

Die Figuren 3a bis 3d zeigen, wie das erfindungsgemäße Halbleiterbauelement mit verschiedenen Strukturen gestaltet werden kann.

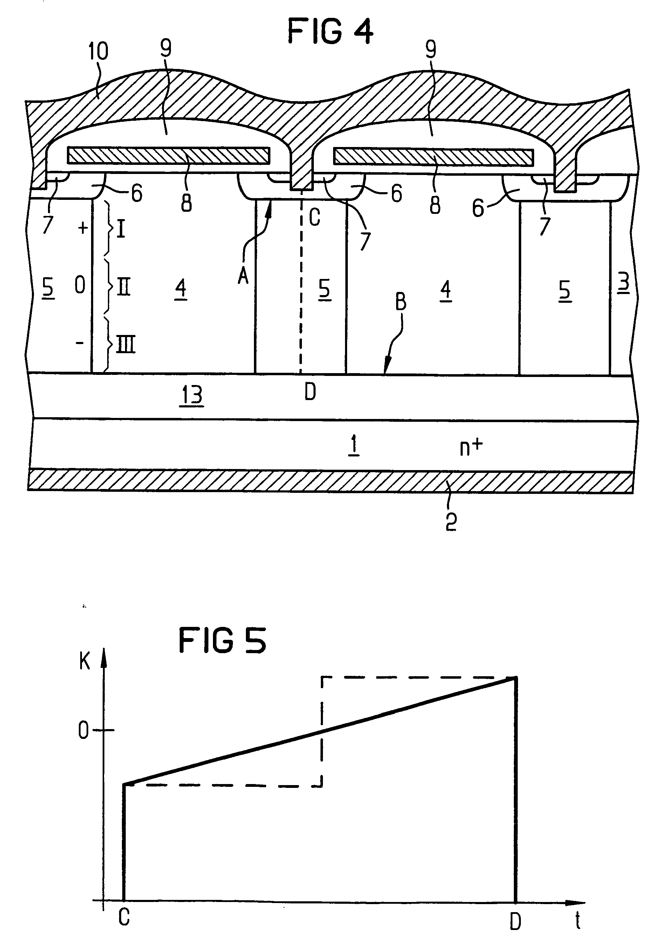

Figur 4 zeigt einen Schnitt durch einen n-Kanal-MOS-Transistor mit einem $n^+$-leitenden Silizium-Halbleitersubstrat 1, einer Drainelektrode 2, einer ersten n-leitenden Schicht 13, einer zweiten Schicht 3 mit n-leitenden Gebieten 4 und p-leitenden Gebieten 5, p-leitenden Zonen 6, n-leitenden Zonen 7, Gateelektroden 8 aus beispielsweise polykristallinem Silizium oder Metall, die in eine Isolierschicht 9 aus beispielsweise Siliziumdioxid eingebettet sind, und einer Source-Metallisierung 10 aus beispielsweise Aluminium. Die p-leitenden Gebiete 5 erreichen auch hier das $n^+$-leitende Halbleitersubstrat nicht.

In Figur 4 sind zur besseren Übersichtlichkeit lediglich die metallischen Schichten schraffiert dargestellt, obwohl auch die übrigen Gebiete bzw. Zonen geschnitten gezeichnet sind.

In den p-leitenden Gebieten 5 sind in einer Zone I ein p-Ladungsüberschuß, in einer Zone II eine "neutrale" Ladung und in Zone III ein n-Ladungsüberschuß vorhanden. Dies bedeutet, daß im Gebiet 5, das eine "p-Säule" bildet, in der Zone I die Ladung der p-Säule die Ladung des umgebenden n-leitenden Gebietes 5 überwiegt, daß weiterhin in der Zone II die Ladung der p-Säule genau die Ladung des umgebenden n-Gebietes 5 kompensiert und daß in der Zone III die Ladung der p-Säule noch nicht die ladung des umgebenden n-Gebiets 5 überwiegt. Wesentlich ist also, daß die Ladung der p-Gebiete 5 variabel ist, während die Ladung der n-Gebiete 4 jeweils konstant ist. Es ist hier wie in den vorangehenden Ausführungsbeispielen aber auch möglich, daß die Ladung der p-leitenden Gebiete 5 konstant ist und die Ladung der n-leitenden Gebiete variiert wird. Ebenso ist es möglich, in beiden Gebieten 4 und 5 die Ladung variabel zu gestalten.

Figur 5 zeigt in einem Schnitt C-D den Verlauf des Kompensationsgrades K über der Tiefe t des n-Kanal-MOS-Transistors: wie aus der Figur 5 zu ersehen ist, steigt der Kompensationsgrad K mit einem konstanten Gradienten oder stufenförmig von dem Punkt C zu dem Punkt D monoton an.

Aus Figur 6 ist zu ersehen, daß über dem Gebiet 5 das elektrische Feld E zwischen den Punkten C und D eine im wesentlichen konstante Krümmung besitzt.

Figur 7 zeigt Kompensationsparabeln für eine konstante und eine variable Dotierung der p-leitenden Gebiete 5 bei dem Ausführungsbeispiel von Figur 4. Auf der Abszisse ist dabei der Kompensationsgrad K in Prozent aufgetragen, während die Ordinate die Durchbruchsspannung U in Volt angibt. Eine Kurve 11 zeigt dabei die Durchbruchsspannung U für eine variable Dotierung, während eine Kurve 12 die Durchbruchsspannung für eine konstante Dotierung darstellt. Es ist deutlich zu ersehen, daß die variable Dotierung eine beträchtliche Absenkung der Durchbruchsspannung von etwa 750 V auf etwa 660 V mit sich bringt. Dafür kann aber ein größerer Bereich des Kompensationsgrades ausgenutzt werden.

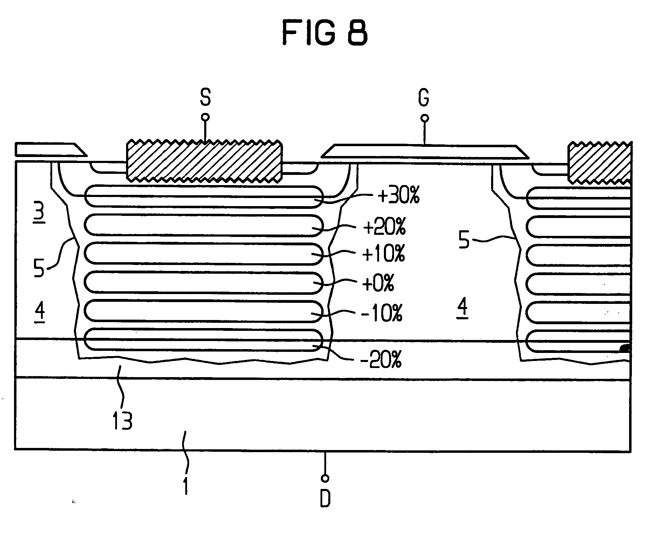

Figur 8 zeigt schließlich ein Zelldesign in einem Schnitt mit Drain D, Source S und Gate G, dem $n^+$-leitenden Halbleitersubstrat 1, einem n-leitenden Halbleiterbereich 13, der n-leitenden Schicht 3 und n-leitenden Gebieten 4 sowie p-leitenden Gebieten 5 für das p-leitende Gebiet 5 unterhalb der Sourceelektrode S sind in Figur 8 die Kompensationsgrade beispielsweise zwischen + 30 % und - 20 % angegeben, wobei ein Kompensationsgrad "0" eine echte Kompensation zwischen n-Dotierung und p-Dotierung bedeutet. Hier variiert also die Dotierung in der "p-Säule" um einen Faktor 3 während die Dotierung in den "n-Säulen" konstant ist.

Figur 9a bis 9c zeigt prinzipiell wie die Figuren 3a bis 3d, wie das erfindungsgemäße Halbleiterbauelement mit verschiedenen Strukturen gestaltet werden kann, die sich bis in den Randbereich erstrecken. Wie aus den Figuren 9a bis c, Figuren 10a bis c und der Figur 11 zu ersehen ist, sind im Halbleiterrandbereich eine Vielzahl von floatenden Zonen 5' vom zweiten Leitungstyp ausgebildet, die von Zwischenzonen 4' vom ersten Leitungstyp getrennt sind. Die Breite der Zwischenzonen 4' und die Breiten der floatenden Zonen 5' sind dabei kleiner als die Breiten der Gebiete 4, 5 innerhalb des Zellenfelds. Die floatenden Zonen 5' und die Zwischenzonen 4' sind so dimensioniert, daß sich deren Ladungsträger bei angelegter Sperrspannung vollständig ausräumen. Die Zonen 5', die im vorliegenden Ausführungsbeispiel schwach p-dotiert ausgebildet sind, sind "floatend", d.h. sie weisen ein undefiniertes Potential auf. Die floatenden Zonen 5' sind voneinander beabstandet, wobei der Bereich zwischen den floatenden Zonen 5' eine Zwischenzone 4' definiert. Diese Zwischenzone 4' weist typischerweise dieselbe Dotierungskonzentration auf, wie die Dotierung in den Zonen 4 innerhalb des Zellenfeldes.

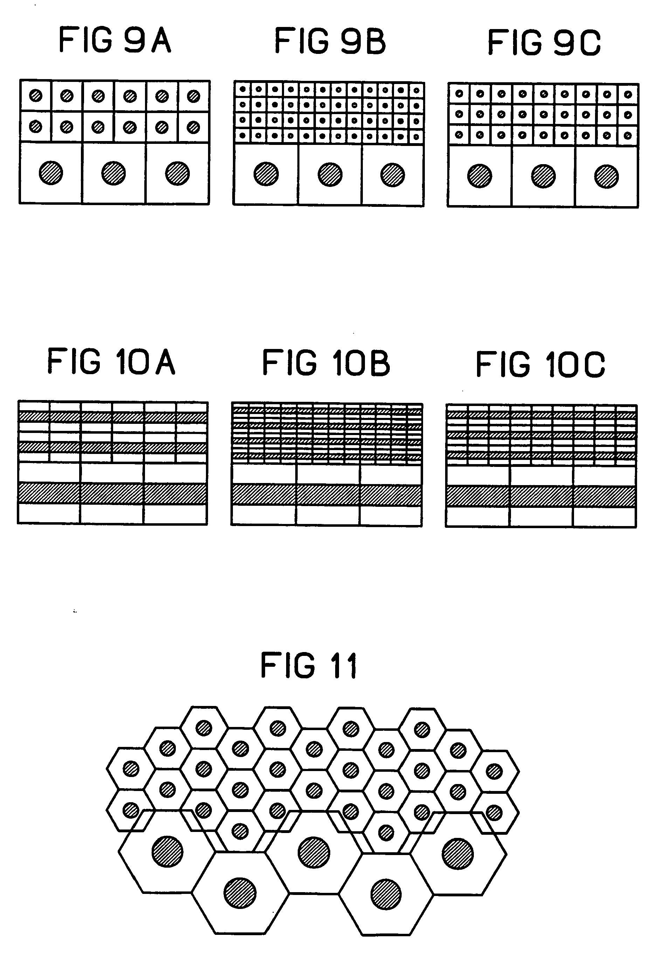

Die Figuren 9a, b und c zeigen verschiedene Variationen der Breiten der Zwischenzonen und der Breiten der floatenden Zonen gegenüber den Grundbreiten im Zellenfeld. Dasselbe zeigen die Figuren 10a, b und c bei der streifenförmigen Randstrukturlayout bzw. die Figur 11 bei einem hexagonalen Randstukturlayout.

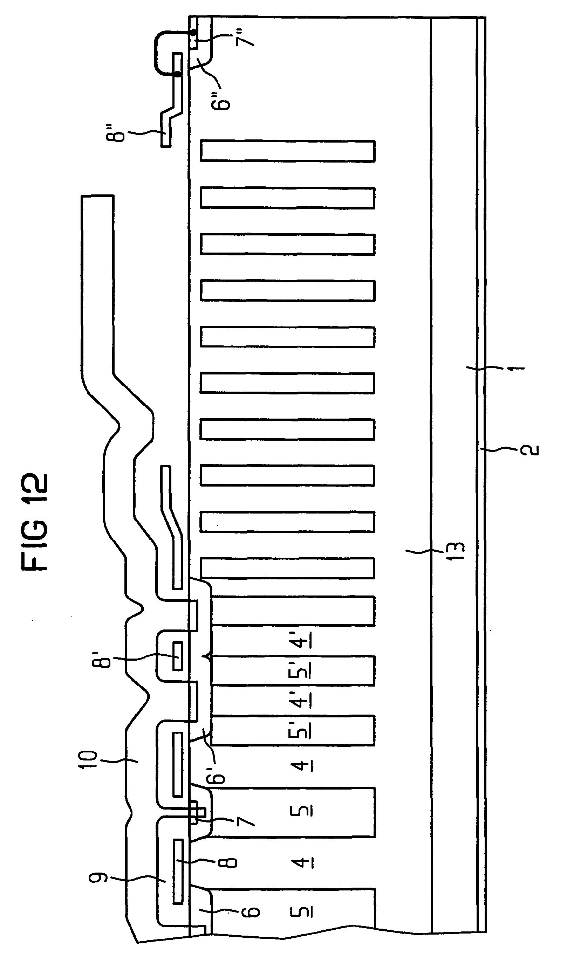

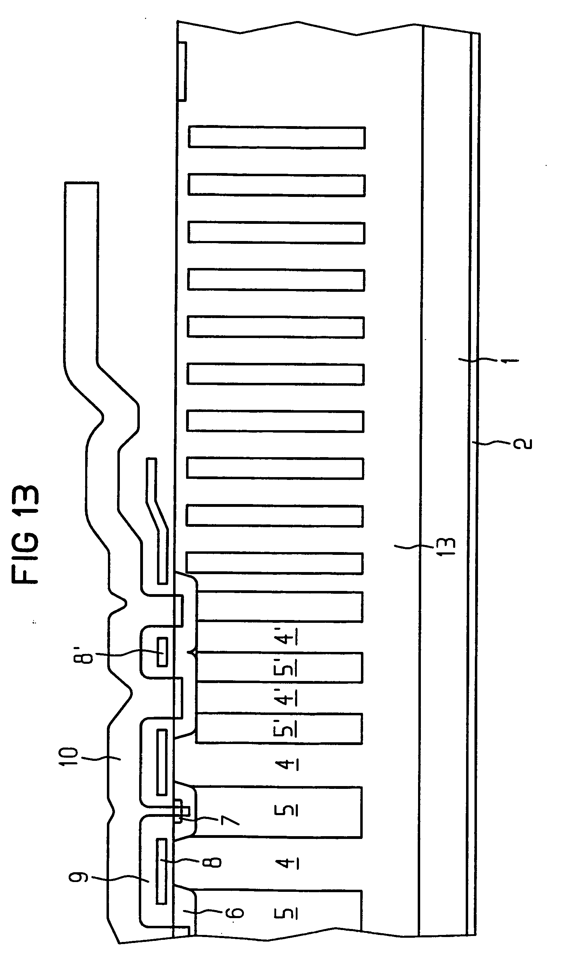

Figur 12 und Figur 13 zeigen den aus Figur 4 bekannten n-Kanal-MOS-Transistor, der um einen intrinsisch kompensierten Randabschluß erweitert ist. Der Transistor ist in bekannter Weise mit einem $n^+$-leitenden Silizium-Halbleitersubstrat 1, einer Drainelektrode 2, einer ersten n-leitenden Schicht 13, einer zweiten Schicht mit n-leitenden Gebieten 4 und p-leitenden Gebieten 5, p-leitenden Zonen 6, n-leitenden Zonen 7, Gate-Elektroden 8 aus beispielsweise polykristallinem Silizium oder Metall, die in eine Isolierschicht 9 aus beispielsweise Siliziumdioxid eingebettet sind, und einer Sourcemetallisierung 10 aus beispielsweise Aluminium, aufgebaut. Dabei sind in der vorliegenden Figur jeweils zwei p-leitende Gebiete 5 und n-leitende Gebiete 4 auf der linken Seite dargestellt. Nach rechts erstrecken sich abwechselnd weitere p-leitende Gebiete 5' und n-leitende Gebiete 4'. Die p-leitenden Gebiete 5' weisen gegenüber den p-leitenden Gebieten 5 in etwa die Hälfte der Breite auf, erstrecken sich doch in etwa gleich weit im $n^-$-leitenden Bereich 13 in Richtung des Substrats 1. Die den Gebieten 4, 5 benachbart liegenden Gebiete 5', 4' sind mit einer p-leitenden Zone 6' verbunden, die über ein Kontaktloch mit der Source-Metallisierung 10 in Verbindung steht. Die p-leitende Zone 6' bildet einen aus dem Stand der Technik bekannten p-Ring. Die p-leitende Zone 6' weist im Gegensatz zum Zellenfeld keine n-leitende Zone auf, um parasitäre Transistoren zu vermeiden. Die n- und p-leitenden Gebiete 4', 5' strecken sich weit über die p-leitende Zone 6' in Richtung des Bauelementrandes. Am äußersten Rand befindet sich eine sogenannte Channel-Stopper-Konfiguration, die aus einer Gate-Elektrode 8", besteht die mit einer n-leitenden Zone 7" elektrisch verbunden ist, welche ihrerseits in einer p-leitenden Zone 6" in dem nleitenden Bereich 13 untergebracht ist.

Eine Alternative zu der in Figur 12 gezeigten Channel-Stopper-Konfiguration bildet der in Figur 13 dargestellte sogenannte Raumladungszonen-Stopper. Dieser Raumladungszonen-Stopper besteht nur aus einer gut leitenden $n^+$-leitenden Zone, die in den $n^-$-leitenden Bereich eingebracht ist.

Beiden Ausführungsbeispielen ist gemeinsam, daß die Kontaktlöcher der p-leitenden Zone 6' gegenüber den Kontaktlöchern in den n- bzw. p-leitenden Zonen 7, 6 wesentlich größer sind. Dies hat zur Folge, daß die Gate-Elektrode 8', die über den Gebieten 4', 5' liegt, gegenüber den Gate-Elektroden 8 des Zellenfeldes wesentlich kleiner ausgebildet ist. Das Raster, in welchem die Gebiete 4', 5' angeordnet sind, ist gegenüber den Gebieten 4, 5 des Zellenfeldes in etwa halb so groß.

Bezugszeichenliste:

| | |
|---|---|
| 1 | Halbleitersubstrat |
| 2 | Drainelektrode |
| 3 | Epitaxieschicht |
| 4 | n-leitendes Gebiet |
| 5 | p-leitendes Gebiet |
| 6 | p-leitende Zone |
| 7 | n-leitende Zone |
| 8 | Gate-Elektrode |
| 9 | Isolierschicht |
| 10 | Source-Metallisierung |
| 11 | Kompensationsparabel für variable Dotierung |
| 12 | Kompensationsparabel für konstante Dotierung |
| 13 | n-leitender Bereich |
| 15 | Drainzone |
| 16 | Sourcezone |
| 17 | Sechseck-Polysilizium-Strukturen |
| 18 | Polysilizium-Öffnung |
| 19 | Aluminium-Kontaktloch |
| 20 | Rechteck-Polysilizium-Strukturen |

| | |
|---|---|
| 21 | Aluminium-Elektroden |
| S | Sourceelektrode |
| G | Gateelektrode |
| D | Drainelektrode |
| K | Kompensationsgrad (%) |
| U | Spannung (Volt) |
| t | Tiefe |
| E | Elektrisches Feld |
| A,B | Flächen |
| 4' | n-leitendes Gebiet |
| 5' | p-leitendes Gebiet |
| 6' | p-leitende Zone |
| 7" | n-leitende Zone |
| 8" | Gate-Elektrode |
| 6" | p-leitende Zone |
| 8' | Gate-Elektrode |

**Patentansprüche**

1. Halbleiterbauelement mit einem einen sperrenden pn-Übergang aufweisenden Halbleiterkörper, einer ersten Zone (16, 7) eines ersten Leitungstyps, die mit einer ersten Elektrode (10) verbunden ist und an eine den sperrenden pn-Übergang bildende Zone (6) eines zweiten, zum ersten Leitungstyp entgegengesetzten Leitungstyps angrenzt, und mit einer zweiten Zone (15, 1) des ersten Leitungstyps, die mit einer zweiten Elektrode (2) verbunden ist, wobei die der zweiten Zone (15, 1) zugewandte Seite der Zone (6) des zweiten Leitungstyps eine erste Oberfläche (A) bildet und im Bereich zwischen der ersten Oberfläche (A) und einer zweiten Oberfläche (B), die zwischen der ersten Oberfläche (A) und der zweiten Zone (15, 1) liegt, Gebiete (4, 5) des ersten und des zweiten Leitungstyps ineinander verschachtelt sind,
**dadurch gekennzeichnet, dass**
die Gebiete (4, 5) des ersten und des zweiten Leitungstyps derart variabel dotiert sind, dass in einem an die erste Oberfläche (A) angrenzenden Bereich (I) der ineinander verschachtelten Gebiete (4, 5) Dotierstoffatome des zweiten Leitungstyps und in einem an die zweite Oberfläche (B) angrenzenden Bereich (III) der ineinander verschachtelten Gebiete (4, 5) Dotierstoffatome des ersten Leitungstyps überwiegen.

2. Halbleiterbauelement nach Anspruch 1,
**dadurch gekennzeichnet,**
**daß** die zweite Oberfläche (B) von der zweiten Zone (15, 1) beabstandet ist, so daß die ineinander verschachtelten Gebiete (4, 5) des ersten und des zweiten Leitungstyps nicht bis zur zweiten Zone (15, 1) reichen.

3. Halbleiterbauelement nach Anspruch 1,
**dadurch gekennzeichnet,**
**daß** die zweite Oberfläche (B) mit der der ersten Zone (16, 7) zugewandten Oberfläche der zweiten Zone (15, 1) zusammenfällt, so daß die ineinander verschachtelten Gebiete (4, 5) des ersten und als zweiten Leitungstyps bis zur zweiten Zone (15, 1) reichen.

4. Halbleiterbauelement nach Anspruch 1,
**dadurch gekennzeichnet,**
**daß** zwischen der zweiten Oberfläche (B) und der zweiten Zone (15, 1) ein schwach dotierter Bereich (13) des ersten Leitungstyps vorgesehen ist.

5. Halbleiterbauelement nach einem der Ansprüche 1 bis 4
**dadurch gekennzeichnet,**
**daß** zwischen der ersten und der zweiten Oberfläche (A, B) das elektrische Feld einen von beiden Oberflächen aus ansteigenden Verlauf hat.

6. Halbleiterbauelement nach einem der Ansprüche 1 bis 5,
**dadurch gekennzeichnet,**
**daß** ein durch die Dotierung in den Gebieten (4, 5) des ersten und des zweiten Leitungstyps bewirkter Kompensationsgrad zwischen der ersten und der zweiten Oberfläche (A, B) einen monotonen Verlauf hat.

7. Halbleiterbauelement nach Anspruch 6,
   **dadurch gekennzeichnet,**
   **daß** der Kompensationsgrad (K) einen stufenförmigen Verlauf hat.

8. Halbleiterbauelement nach Anspruch 6 oder 7,
   **dadurch gekennzeichnet,**
   **daß** der Kompensationsgrad (K) zwischen der ersten und der zweiten Oberfläche (A, B) um einen Faktor 4 variiert.

9. Halbleiterbauelement nach einem der Ansprüche 1 bis 8,
   **dadurch gekennzeichnet,**
   **daß** der erste Leitungstyp der n-Leitungstyp ist.

10. Halbleiterbauelement nach einem der Ansprüche 1 bis 9,
    **dadurch gekennzeichnet,**
    **daß** die Gebiete (4, 5) des ersten und des zweiten Leitungstyps lateral im Halbleiterkörper angeordnet sind.

11. Halbleiterbauelement nach einem der Ansprüche 1 bis 9,
    **dadurch gekennzeichnet,**
    **daß** die Gebiete (4, 5) des ersten und zweiten Leitungstyps vertikal im Halbleiterkörper angeordnet sind.

12. Halbleiterbauelement nach Anspruch 9,
    **dadurch gekennzeichnet,**
    **daß** in Gebieten (5) des zweiten Leitungstyps ein durch Dotierung bewirkter Kompensationsgrad derart variiert ist, daß nahe der ersten Oberfläche (A) Akzeptorrümpfe und nahe der zweiten Oberfläche (B) Donatorrümpfe dominieren.

13. Halbleiterbauelement nach einem der Ansprüche 1 bis 12,
    **dadurch gekennzeichnet,**
    **daß** die Gebiete (4) in einem Schnitt parallel zur ersten Oberfläche (A) und zur zweiten Oberfläche (B) einen in etwa kreisförmigen Querschnitt aufweisen und eine hexagonale Flächenpackung einnehmen.

14. Halbleiterbauelement nach einem der Ansprüche 1 bis 12,
    **dadurch gekennzeichnet,**
    **daß** die Gebiete (4) in einem Schnitt parallel zur ersten Oberfläche (A) und zur zweiten Oberfläche (B) einen in etwa kreisförmigen Querschnitt aufweisen und eine in etwa quadratische Flächenpackung einnehmen.

15. Halbleiterbauelement nach einem der Ansprüche 1 bis 12,
    **dadurch gekennzeichnet,**
    **daß** die Gebiete (4) in einem Schnitt parallel zur ersten Oberfläche (A) und zur zweiten Oberfläche (B) einen in etwa streifenförmigen Querschnitt aufweisen-.

16. Halbleiterbauelement nach einem der Ansprüche 1 bis 15,
    **dadurch gekennzeichnet,**
    **daß** das Halbleiterbauelement in seinem Randbereich eine hochspannungsfeste Grundstruktur aufweist, die aus mehreren floatenden Zonen (5') vom zweiten Leitungstyp besteht, die von Zwischenzonen (4') vom ersten Leitungstyp getrennt sind, wobei die Breite der Zwischenzonen und die Breite der floatenden Zonen (4') kleiner als die Breiten der Gebiete (4, 5) sind und sich die Ladungsträger der floatenden Zonen (5') und der Zwischenzonen (4') bei angelegter Sperrspannung vollständig ausräumen.

17. Halbleiterbauelement nach Anspruch 16,
    **dadurch gekennzeichnet,**
    **daß** am äußersten Rand des Randbereiches des Halbleiterbauelements mindestens ein Raumladungszonenstopper vorgesehen ist.

18. Halbleiterbauelement nach Anspruch 17,
    **dadurch gekennzeichnet,**

**daß** der Raumladungszonenstopper ein zwischen der ersten Oberfläche (A) und der zweiten Oberfläche (B) angeordnetes, stark dotiertes Gebiet vom ersten Leitungstyp aufweist.

19. Halbleiterbauelement nach Anspruch 18,
   **dadurch gekennzeichnet,**
   **daß** der Raumladungszonenstopper ein Damage-implantiertes Gebiet aufweist.

20. Halbleiterbauelement nach Anspruch 19,
   **dadurch gekennzeichnet,**
   **daß** der Raumladungszonenstopper eine metallische oder eine Polysilizium enthaltende Elektrode aufweist, die an den Halbleiterkörper angeschlossen ist.

21. Verfahren zum Herstellen des Halbleiterbauelements nach einem der Ansprüche 1 bis 20,
   **dadurch gekennzeichnet,**
   **daß** in einzelnen Halbleiterschichten durch Änderung einer Ionenimplantationsdosis der Kompensationsgrad (K) in den Gebieten des zweiten Leitungstyps kontinuierlich verändert wird.

22. Verfahren zum Herstellen des Halbleiterbauelements nach einem der Ansprüche 1 bis 20,
   **dadurch gekennzeichnet,**
   **daß** in einzelnen Epitaxieschichten durch Änderung der Epitaxiedotierung der Kompensationsgrad (K) in den Gebieten des zweiten Leitungstyps kontinuierlich verändert wird.

**Claims**

1. Semiconductor component comprising a semiconductor body having a blocking pn junction, comprising a first zone (16, 7) of a first conductivity type, which is connected to a first electrode (10) and adjoins a zone (6) of a second conductivity type, which is opposite to the first conductivity type, said zone (6) forming the blocking pn junction, and comprising a second zone (15, 1) of the first conductivity type, which is connected to a second electrode (2), that side of the zone (6) of the second conductivity type which faces the second zone (15, 1) forming a first surface (A) and regions (4, 5) of the first and of the second conductivity type being interleaved in one another in the region between the first surface (A) and a second surface (B) lying between the first surface (A) and the second zone (15, 1), **characterized in that**
   the regions (4, 5) of the first and of the second conductivity type are doped variably in such a way that dopant atoms of the second conductivity type are predominant in a region (I) of the mutually interleaved regions (4, 5) which adjoins the first surface (A) and dopant atoms of the first conductivity type are predominant in a region (III) of the mutually interleaved regions (4, 5) which adjoins the second surface (B).

2. Semiconductor component according to Claim 1,
   **characterized**
   **in that** the second surface (B) is spaced apart from the second zone (15, 1), so that the mutually interleaved regions (4, 5) of the first and of the second conductivity type do not reach as far as the second zone (15, 1).

3. Semiconductor component according to Claim 1,
   **characterized**
   **in that** the second surface (B) coincides with that surface of the second zone (15, 1) which faces the first zone (16, 7), so that the mutually interleaved regions (4, 5) of the first and of the second conductivity type reach as far as the second zone (15, 1) .

4. Semiconductor component according to Claim 1,
   **characterized**
   **in that** a lightly doped region (13) of the first conductivity type is provided between the second surface (B) and the second zone (15, 1).

5. Semiconductor component according to one of Claims 1 to 4,
   **characterized**
   **in that**, between the first and the second surface (A, B), the electric field has a profile which rises from both surfaces.

**6.** Semiconductor component according to one of Claims 1 to 5,
**characterized**
**in that** a degree of compensation effected by the doping in the regions (4, 5) of the first and of the second conductivity type, between the first and the second surface (A, B), has a monotonic profile.

**7.** Semiconductor component according to Claim 6,
**characterized**
**in that** the degree of compensation (K) has a stepped profile.

**8.** Semiconductor component according to Claim 6 or 7,
**characterized**
**in that** the degree of compensation (K), between the first and the second surface (A, B), varies by a factor of 4.

**9.** Semiconductor component according to one of Claims 1 to 8,
**characterized**
**in that** the first conductivity type is the n conductivity type.

**10.** Semiconductor component according to one of Claims 1 to 9,
**characterized**
**in that** the regions (4, 5) of the first and of the second conductivity type are arranged laterally in the semiconductor body.

**11.** Semiconductor component according to one of Claims 1 to 9,
**characterized**
**in that** the regions (4, 5) of the first and of the second conductivity type are arranged vertically in the semiconductor body.

**12.** Semiconductor component according to Claim 9,
**characterized**
**in that**, in regions (5) of the second conductivity type, a degree of compensation effected by doping is varied in such a way that acceptor cores are dominant near the first surface (A) and donor cores are dominant near the second surface (B).

**13.** Semiconductor component according to one of Claims 1 to 12,
**characterized**
**in that** the regions (4), in a section parallel to the first surface (A) and to the second surface (B), have an approximately circular cross-section and take up a hexagonal square area packing.

**14.** Semiconductor component according to one of Claims 1 to 12,
**characterized**
**in that** the regions (4), in a section parallel to the first surface (A) and to the second surface (B), have an approximately circular cross-section and take up an approximately square area packing.

**15.** Semiconductor component according to one of Claims 1 to 12,
**characterized**
**in that** the regions (4) in a section parallel to the first surface (A) and to the second surface (B) have an approximately strip-type cross section.

**16.** Semiconductor component according to one of Claims 1 to 15,
**characterized**
**in that** the semiconductor component has, in its edge region, a high-voltage-resistant basic structure comprising a plurality of floating zones (5') of the second conductivity type, which are separated from intermediate zones (4') of the first conductivity type, the width of the intermediate zones and the width of the floating zones (5') being less than the widths of the regions (4, 5) and the charge carriers of the floating zones (5') and of the intermediate zones (4') being fully depleted when reverse voltage is applied.

**17.** Semiconductor component according to Claim 16,
**characterized**

**in that** at least one space charge zone stopper is provided at the outermost edge of the edge region of the semiconductor component.

18. Semiconductor component according to Claim 17,
**characterized**
**in that** the space charge zone stopper has a heavily doped region of the first conductivity type arranged between the first surface (A) and the second surface (B).

19. Semiconductor component according to Claim 18,
**characterized**
**in that** the space charge zone stopper has a damage-implanted region.

20. Semiconductor component according to Claim 19,
**characterized**
**in that** the space charge zone stopper has a metallic or a polysilicon-containing electrode connected to the semiconductor body.

21. Method for producing the semiconductor component according to one of Claims 1 to 20,
**characterized**
**in that**, in individual semiconductor layers, by changing an ion implantation dose, the degree of compensation (K) is continuously altered in the regions of the second conductivity type.

22. Method for producing the semiconductor component according to one of Claims 1 to 20,
**characterized**
**in that**, in individual epitaxial layers, by changing the epitaxial doping, the degree of compensation (K) is continuously altered in the regions of the second conductivity type.

**Revendications**

1. Elément semiconducteur avec un corps semiconducteur présentant une jonction pn à effet barrage, une première zone (16, 7) d'un premier type de conduction qui est reliée à une première électrode (10) et qui avoisine une zone (6) formant la jonction pn à effet barrage et d'un second type de conduction opposé au premier type de conduction, et avec une seconde zone (15, 1) du premier type de conduction, qui est reliée avec une seconde électrode (2), du type selon lequel le côté de la zone (6) du second type de conduction, dirigé vers la seconde zone (15, 1), constitue une première surface (A), et selon lequel dans le domaine situé entre la première surface (A) et une seconde surface (B), qui se situe entre la première surface (A) et la seconde zone (15, 1), des régions (4, 5) du premier et du second type de conduction sont mutuellement enchevêtrées,
**caractérisé en ce que**
les régions (4, 5) du premier et du second type de conduction sont dopées de manière variable, de telle sorte que dans un domaine (I) des régions (4, 5) mutuellement enchevêtrées et qui avoisine la première surface (A), prédominent des atomes de matière dopante du second type de conduction et que, dans un domaine (III) des régions (4, 5) mutuellement enchevêtrées et qui avoisine la seconde surface (B), prédominent des atomes de matière dopante du premier type de conduction.

2. Elément semiconducteur selon la revendication 1,
**caractérisé en ce que**
la seconde surface (B) est espacée de la seconde zone (15, 1), de telle façon que les régions (4, 5) du premier et du second type de conduction, mutuellement enchevêtrées ne parviennent pas jusqu'à la seconde zone (15, 1).

3. Elément semiconducteur selon la revendication 1,
**caractérisé en ce que**
la seconde surface (B) vient en coïncidence avec la surface de la seconde zone (15, 1), dirigée vers la première zone (16, 7), de telle façon que les régions (4, 5) du premier et du second type de conduction, mutuellement enchevêtrées parviennent jusqu'à la seconde zone (15, 1).

4. Elément semiconducteur selon la revendication 1,
**caractérisé en ce que**

entre la seconde surface (B) et la seconde zone (15, 1) est prévu un domaine (13) du premier type de conduction et faiblement dopé.

**5.** Elément semiconducteur selon l'une des revendications 1 à 4,
    **caractérisé en ce que**
    entre la première et la seconde surface (A, B) le champ électrique a un profil croissant à partir des deux surfaces.

**6.** Elément semiconducteur selon l'une des revendications 1 à 5,
    **caractérisé en ce que**
    un degré de compensation influencé par la dotation dans les régions (4, 5) du premier et du second type de conduction a un profil monotone entre la première et la seconde surface (A, B).

**7.** Elément semiconducteur selon la revendication 6,
    **caractérisé en ce que**
    le degré de compensation (K) a un profil en paliers.

**8.** Elément semiconducteur selon la revendication 6 ou 7,
    **caractérisé en ce que**
    le degré de compensation (K) varie d'un facteur 4 entre la première et la seconde surface (A, B).

**9.** Elément semiconducteur selon l'une des revendications 1 à 8,
    **caractérisé en ce que**
    le premier type de conduction est le type de conduction n.

**10.** Elément semiconducteur selon l'une des revendications 1 à 9,
    **caractérisé en ce que**
    les régions (4, 5) du premier et du second type de conduction sont en disposition latérale dans le corps semiconducteur.

**11.** Elément semiconducteur selon l'une des revendications 1 à 9,
    **caractérisé en ce que**
    les régions (4, 5) du premier et du second type de conduction sont en disposition verticale dans le corps semiconducteur.

**12.** Elément semiconducteur selon la revendication 9,
    **caractérisé en ce que**
    dans les régions (5) du second type de conduction on fait varier le degré de compensation provoqué par dotation, de telle sorte que près de la première surface (A) dominent des rangées d'accepteurs et que près de la seconde surface (B) dominent des rangées de donneurs.

**13.** Elément semiconducteur selon l'une des revendications 1 à 12,
    **caractérisé en ce que**
    les régions (4) dans une coupe parallèle à la première surface (A) et à la seconde surface (B) présentent une section transversale sensiblement circulaire et adoptent une disposition surfacique hexagonale.

**14.** Elément semiconducteur selon l'une des revendications 1 à 12,
    **caractérisé en ce que**
    les régions (4) dans une coupe parallèle à la première surface (A) et à la seconde surface (B) présentent une section transversale sensiblement circulaire et adoptent une disposition surfacique sensiblement carrée.

**15.** Elément semiconducteur selon l'une des revendications 1 à 12,
    **caractérisé en ce que**
    les régions (4) dans une coupe parallèle à la première surface (A) et à la seconde surface (B) présentent une section transversale sensiblement en forme de bandes.

**16.** Elément semiconducteur selon l'une des revendications 1 à 15,
    **caractérisé en ce que**
    l'élément semiconducteur présente dans sa zone de bord une structure de base résistant aux tensions élevées, qui se compose d'une pluralité de zones flottantes (5') de second type de conduction, qui sont séparées par des zones intermédiaires (4') de premier type de conduction, la largeur des zones intermédiaires et la largeur des zones flottantes (5') étant plus petites que les largeurs des régions (4, 5) et les porteurs de charge des zones flottantes (5') et des zones intermédiaires (4') s'annihilant complètement lors de l'application d'une tension de barrage.

**17.** Elément semiconducteur selon la revendication 16,
**caractérisé en ce que**
à la périphérie extérieure du domaine de bord de l'élément semiconducteur est prévu au moins un élément d'arrêt de zones spatiales de charge.

**18.** Elément semiconducteur selon la revendication 17,
**caractérisé en ce que**
l'élément d'arrêt de zones spatiales de charge présente une région fortement dopée, de premier type de conduction et disposée entre la première surface (A) et la seconde surface (B).

**19.** Elément semiconducteur selon la revendication 18,
**caractérisé en ce que**
l'élément d'arrêt de zones spatiales de charge présente une région implantée jusqu'à endommagement.

**20.** Elément semiconducteur selon la revendication 19,
**caractérisé en ce que**
l'élément d'arrêt de zones spatiales de charge présente une électrode métallique ou une électrode contenant du polysilicium, qui est raccordée au corps semiconducteur.

**21.** Procédé de fabrication de l'élément semiconducteur selon l'une des revendications 1 à 20,
**caractérisé en ce que**
dans des couches individuelles semiconductrices et par modification de la dose d'implantation d'ions, on fait varier de manière continue le degré de compensation (K) dans les régions du second type de conduction.

**22.** Procédé de fabrication de l'élément semiconducteur selon l'une des revendications 1 à 20,
**caractérisé en ce que**
dans des couches individuelles d'épitaxie et par modification de la dotation d'épitaxie, on fait varier de manière continue le degré de compensation (K) dans les régions du second type de conduction.

17

EP 1 114 466 B1

## FIG 1

## FIG 2

## FIG 3A

## FIG 3B

## FIG 3C

## FIG 3D

## FIG 4

## FIG 5

## FIG 6

## FIG 7

# FIG 8

FIG 9A

FIG 9B

FIG 9C

FIG 10A

FIG 10B

FIG 10C

FIG 11

# FIG 12

EP 1 114 466 B1

FIG 13